# EUROPEAN PATENT APPLICATION

(11) **EP 2 728 621 A1**
(43) Date of publication of application: **07.05.2014**
(21) Application number: 12191252.1
(22) Date of filing: 05.11.2012
(51) Int. Cl.: H01L 29/745

(54) **Insulated gate power semiconductor device**

(71) Applicant: ABB Technology AG, 8050 Zürich (CH)
(72) Inventor: Bauer, Friedhelm, 6714 Semione (CH); Rahimo, Munaf, 5619 Uezwil (CH)
(74) Representative: ABB Patent Attorneys

(57) **Abstract**

An insulated gate power semiconductor device (1) with a four-layer thyristor structure, having an emitter electrode (2) comprising a plurality of first contact areas (23) and at least one second contact area (24), a collector electrode (25), a drift layer (5) of a first conductivity type, which is arranged between the emitter electrode (2) and the collector electrode (25), a collector layer (6) of a second conductivity type arranged between the drift layer (5) and the collector electrode (25), a plurality of emitter layers (3) of the first conductivity type, each of which having a higher doping concentration than the drift layer (5) and contacting the emitter electrode (2) at one first contact area (23) or the at least one second contact area (24), a base layer (4) of the second conductivity type arranged between the drift layer (5) and the emitter layers (3) and completely separated from the first contact areas (23) by the emitter layers (3), a plurality of first gate electrodes (74, 71), wherein each first contact area (23) is arranged between at least two directly neighboured first gate electrodes (74, 71), and at least one second gate electrode (84, 81), wherein the at least one second contact area (24) is arranged adjacent to the at least one second gate electrode (84, 81) and wherein the at least one second gate electrode extends to the drift layer (5).

## Description

### Technical Field

The invention relates to the field of power electronics and more particularly to an insulated gate power semiconductor device according to the preamble of the independent claim 1.

### Background Art

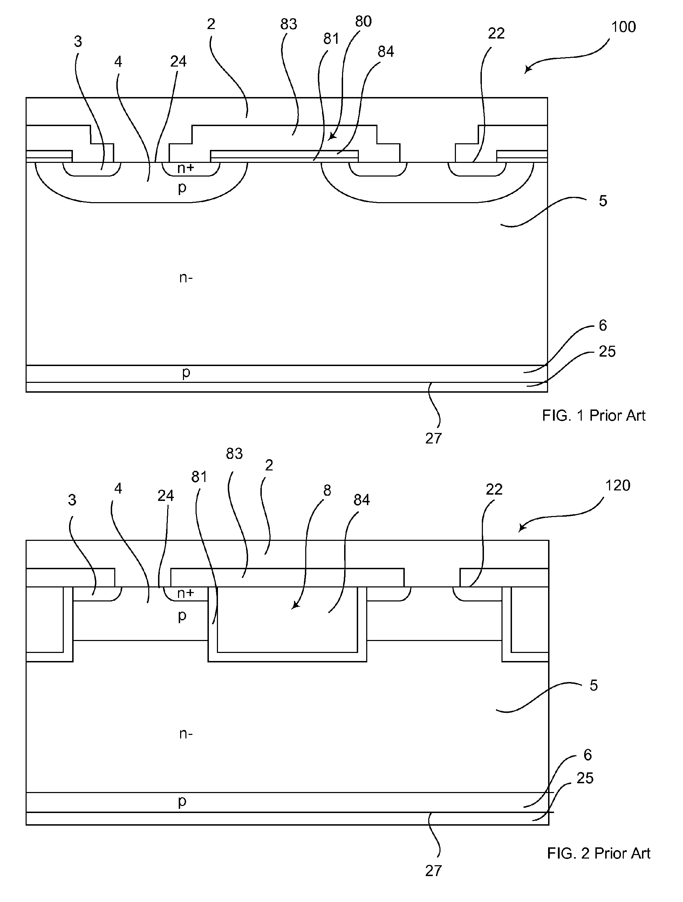

In Fig. 1 a prior art insulated gate bipolar transistor (IGBT) 100 is shown, which comprises between an emitter electrode 2 on an emitter side 22 and a collector electrode 25 on a collector side 27 opposite to the emitter side 22 an (n+) doped emitter layers 3 in form of n source regions and a p doped base layer 4, both of which contact the emitter electrode 2 in a second contact area 24, an (n-) doped drift layer 5 and a p doped collector layer 6.

A gate electrode formed as a second planar gate electrode 80 is arranged on top of the emitter side 22. A second electrically insulating layer 81 is arranged on the emitter side 22, which is covered by a fourth insulating layer 83. In between the second and fourth electrically insulating layers 81, 83, a second electrically conductive layer 84 is embedded. The layers 81, 83 and 84 form the second planar gate electrode 80.

In Fig. 2, another prior art IGBT 120 is shown having a second trench gate electrode 8. The second trench gate electrode 8 is arranged on the emitter side 22, which comprises a second electrically conductive layer 84 and a second electrically insulating layer 81, which surrounds and thus separates the second electrically conductive layer 84 from the drift layer 5, base layer 4 and the at least one n source region 3. A fourth insulating layer 83 is arranged between the second electrically conductive layer 84 and the emitter electrode 2. Again, the p base layer 4 as well as the n source regions 3 contact the emitter electrode 2 at the second contact areas 24.

Efforts have been made to reduce the size of IGBT cells (the layers arranged between two gate electrodes) in order to reduce conduction losses. However, due to the inherent JFET resistance and the need for cell layouts guaranteeing short-circuit current capability, downsizing of the IGBT cell structures has stopped far before reaching technological limits of photolithography. Improvements in conduction losses have been made for trench gate IGBTs by the introduction of a highly doped n enhancement layer between the p base layer 4 and the drift layer 5 (which devices are called Carrier Stored Trench-gate Bipolar Transistor; CSTBT), but also these devices have the same structural limits as the other prior art devices mentioned above.

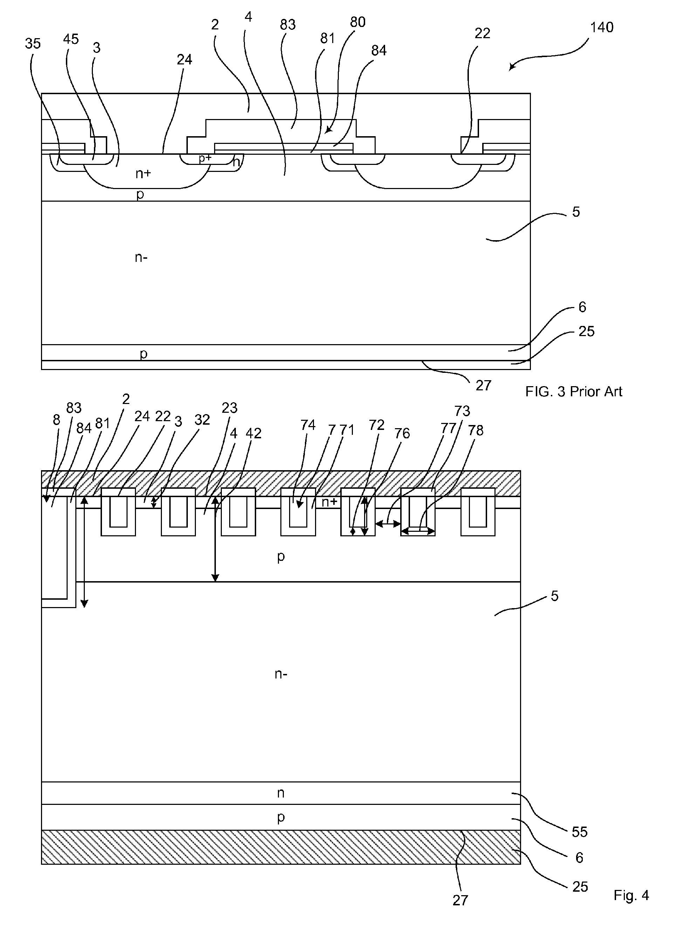

Fig. 3 shows a prior art MOS controlled thyristor (MCZ) 140, which comprises a planar gate electrode 80 as described before. The MCT further comprises an n emitter layer 3, which is in contact to the emitter electrode 2, a p short region 45, which is also in contact to the emitter electrode 2 and extends to a region below the gate electrode 80. An n channel region 35, which is arranged below the gate electrode 80 separates the p short region 45 from the drift layer 5. Due to the four layer pnpn structure the MCT tends to latch easily, which results in an extremely low forward voltage. Each contact of the n emitter layer 3 to the emitter electrode 2 and the p short regions 4 to the emitter electrode 2 needs extra space at the contact opening, which results in a poor safe operating area (SOA). Additionally to the cells shown in Fig. 3, the MCTs need another gate for switching on the device, which gate has the same design like the gates shown in Fig. 1 or 2.

Historically, the MOS-controlled thyristor (MCT) could not compete with the insulated gate bipolar transistor (IGBT) because it was always plagued by a rather low maximum turn-off current at the chip level. Despite having conduction losses lower than the IGBT, the tendency of the MCT to generate current filaments with very high local current densities beyond the controllability limit resulted in a failure to cope with realistic failure mode conditions in power electronic systems. Although the IGBT has a significantly higher on-state voltage drop, its ruggedness and the ease to parallel chips has made it the preferred power semiconductor component.

### Disclosure of Invention

It is thus an object of the invention to provide a power semiconductor device with lower conduction losses than for prior art semiconductor devices (IGBT) maintaining at the same time the low level of turn-off switching losses of prior art devices, i. e., without increasing turn-off switching losses.

This object is achieved by a power semiconductor device according to claim 1.

The inventive insulated gate power semiconductor device has an emitter electrode on an emitter side and a collector electrode on a collector side, which collector side is arranged opposite to the emitter side. The emitter electrode comprises a plurality of first contact areas and at least one second contact area for a contact of the emitter electrode to a layer of the first or second conductivity type in the device. A drift layer of a first conductivity type is arranged between the emitter side and the collector side. Exemplarily, the drift layer has a constant, low doping concentration. A collector layer of a second conductivity type, which is different from the first conductivity type, is arranged between the drift layer and the collector electrode.

A plurality of emitter layers of the first conductivity type is arranged at the emitter side. Each of the emitter layers has a higher doping concentration than the drift layer. Each of the emitter layers contacts the emitter electrode at one of the plurality of first contact areas or at one of the at least one second contact area. The emitter layers have an emitter layer depth, which is the maximum extension of the plurality of emitter layers from the emitter side.

A base layer of the second conductivity type is arranged between the drift layer and the plurality of emitter layers. The base layer has a base layer depth, which is the maximum extension of the base layer from the emitter side and in a direction perpendicular to the emitter side.

A plurality of primary gate electrodes is arranged at the emitter side. Each of the primary gate electrodes comprises a first electrically conductive layer and a first insulating layer, which separates the first electrically conductive layer from any layer or region of the first and second conductivity type being in touch with the plurality of primary gate electrodes. Each first contact area is arranged between at least two directly neighboured primary gate electrodes. The emitter layer thus extends from one primary gate electrode to a directly neighboured primary gate electrode without e.g. another gate electrode being arranged in between.

At least one secondary gate electrode is also arranged at the emitter side. Each of the secondary gate electrodes comprises a second electrically conductive layer and a second insulating layer, which separates the second electrically conductive layer from any layer or region of the first and second conductivity type being in touch with the at least one secondary gate electrode The at least one second contact area is arranged directly adjacent to the at least one secondary gate electrode (i.e. the second contact area adjoins the insulating layer of the directly adjacent lying secondary gate electrode) and the at least one secondary gate electrode extends to the drift layer. Exemplarily, the first and second electrically conductive layers are both made from the same material, e.g. in form of poly silicon layers.

The base layer is completely separated from the plurality of first contact areas by the plurality of emitter layers. The emitter electrode thus electrically contacts only the emitter layers at its first contact areas.

The inventive semiconductor device, thus, comprises a four layer pnpn structure similar to those known from prior art MCTs. However, the inventive device avoids the weak points of these devices in two crucial aspects: first, shorting of the n-emitter layers to the p-base layer is accomplished without the need for a p short region contacting the emitter electrode as it is the case for a prior art MCT. Such p short regions need space and therefore, minimization of the prior art MCT cells, which is mandatory to achieve high MCT turn-off current densities, is limited by the the spacing requirement. By completely eliminating such a p short region, the active cell size can be reduced significantly in the inventive semiconductor device, which has a positive effect on the conduction loss and the safe operating area (SOA) of the device.

Second, the ability to inject electrons from the n-emitter layer into the p-base layer is drastically reduced as the n-emitter layer is conceived in such a way as to permit a large amount of holes from the anode to pass through this layer and reach the emitter metal electrode with little recombination taking place in the n-emitter layer, thereby causing very weak emission of electrons into the p-base layer. This quality of a weak emitter layer is also referred to as "highly transparent". The n-emitter transparency has a low upper limit, which is set by the need to create additional paths for the holes across the n-emitter layer during turn-off. For this purpose, the vertical edges of the n-emitter layers facing the gate insulator and the first gate electrode become inverted with respect to the conduction type (hole inversion channel) when a convenient gate bias is applied (gate-emitter voltage V_{ge} < threshold voltage Vₜₕ₋). These hole inversion channels have very low resistivity and handle the total hole current during turn-off. Thus, the small regeneration of holes in the center of the n-emitter layer with concomitant injection of electrons into the p base layer during on-state will cease completely contributing to a very high turn-off capability.

When the polarity of the gate voltage is reversed (gate-emitter voltage Vge > threshold voltage Vth+; turn-on and on-state), the channel will favour electron conduction from the n-emitter layer now acting as a MOS source for electrons along the inverted p-base and futher across the forward-biased junction between p-base layer and n-drift layer (common action of a npnp - thyristor structure in on-state).

The channel develops at the interface of the semiconductor (n-emitter layer, p-base layer and eventually n-drift layer) and the gate insulating layer of the MOS system. The inventive device thus unites characteristics of prior art MCTs and IGBTs under the condition of minimum cell dimensions.

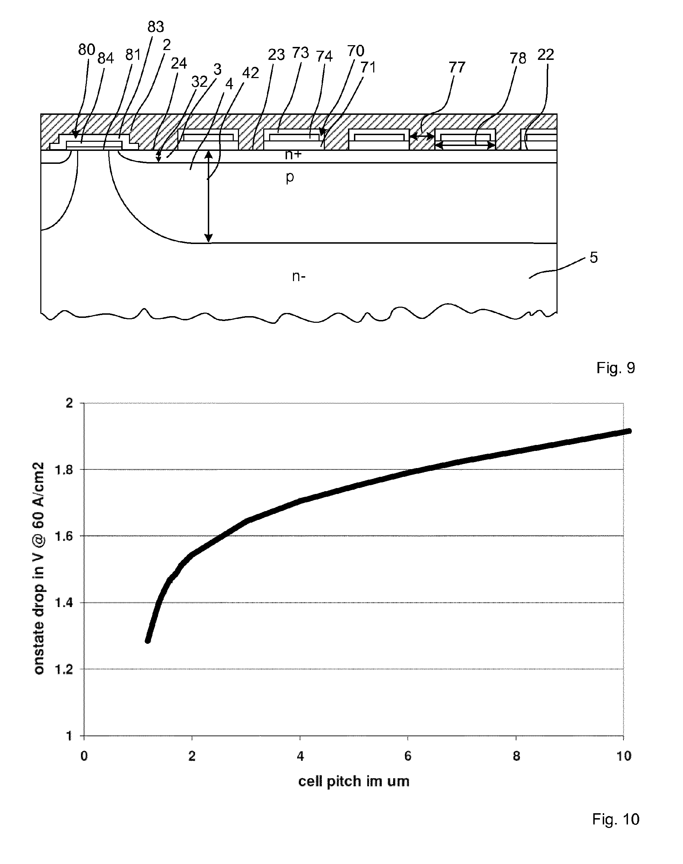

With the inventive design, extremely low conduction losses can be realized as indicated in Fig. 10 at 60 A/cm² and 400 K. The voltage drops are close or even below 1.5 V for a cell pitch of at most 2 µm and a trench depth of 7 µm. For a 3.3 kV device with a 1 µm cell pitch (distance from one first trench gate electrode to the next) and 1 µm deep first trench gate electrodes (not shown in Fig. 10) an on state voltage drop of 1.675 V is achieved at these conditions. The collector side of such a device can be chosen like for prior art planar 3.3 kV IGBTs (380 µm device thickness, 1.2*10¹³ cm⁻³ (n-) drift layer doping concentration, n-buffer layer, 8 µs carrier lifetime for electrons and 2 µs for holes).

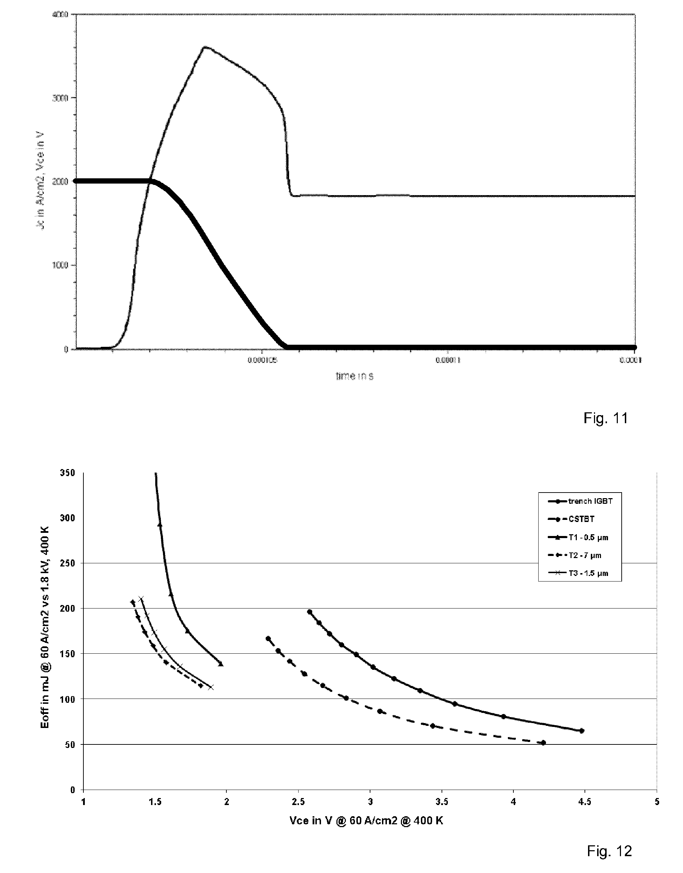

Electron and hole current density plots of different prior art and inventive devices are shown in Fig. 12 at typical on-state current (60 A/cm² at 400 K). For these conditions, the inventive high density gate electrode design provides homogeneously distributed electron and hole current densities across the p-base layer. The hole current density is homogeneous in the p-base layer between two first trench gate electrodes and in particular in the n- emitter layer since the trench gate electrodes affect the hole current distribution already before it reaches the injecting PN junction. On-state drop between 1.5 and 2 V is shown for inventive devices, whereas a turn-off loss level of 100 to 150 mJ/cm² with respect to the turn-off condition 60 A/cm² versus 1800 V at 400 K is achieved. A prior art trench IGBT with a cell pitch of 7 µm shows a voltage drop of around 2.9 to 3.5 V and even with an n-enhancement layer (CSTBT) still of 2.3 to 2.9 V.

To allow strong inversion of the conduction type in the n-emitter layer by means of an inversion MOS channel (turn-off and off-state), it is advantageous that the maximum / peak concentration in the n-emitter layer is limited to permit the establishment of an inversion layer at practicable gate bias values (threshold voltage, depends on doping density and gate oxide thickness). With positive gate voltage > Vₜₕ₊ an inversion layer develops at the p-base layer surface along the trench wall, e.g. silicon - insulating layer, e.g. silicon dioxide, interface as a primary low resistance path for electrons from the n-emitter metal electrode and the n-emitter layer further into the p-base layer. This is the main path for electrons in the inventive device when in on-state (up to 80 or 90% of total electron current at the emitter). The secondary path of electrons coincides with the well-known bipolar injection of electrons from an emitter layer into a base layer (forward biased pn junction). For an exemplary design or layout of the inventive device, the resulting n-emitter layer would thus have a very low injection efficiency for electrons into the p-base layer (where they become minority carriers) achieved by a low peak doping concentration and a shallow n-emitter layer (resulting in low total n-dopant in this layer).

During turn-off or static blocking, a negative gate voltage exceeding Vₜₕ₋ is applied to the gate; an inversion / accumulation layer for holes now develops at the same interface, where electrons flow during on-state. This becomes the primary low resistance path for holes from the p base layer into the emitter metal electrode during turn-off and off-state. It most effectively shorts / bypasses emitter action in the n-emitter layer and so constitutes the high turn-off capability of the inventive device. The first trench gate electrodes attract holes and offer conducting channels through the n-emitter (inverted n-emitter surface) into the emitter electrode. This allows efficient extraction of holes through n-emitter layers without immediate return of injected electrons. Therefore, there is no need to arrange for a p-base layer directly contacted by the emitter electrode as in prior art power semiconductor devices like insulated gate bipolar transistors (IGBTs).

Therefore, the turn-off capability of the inventive devices are very high. Even at 2000 A/cm² versus 1800 V and 400 K, the turn-off limit due to dynamic avalanche was not reached yet as shown in Fig. 11, wherein the thick curve shown below in Fig. 11 representing the current, whereas the thinner, upper curves represent the voltage of an inventive device.

As the p-base layer is not contacted by the emitter electrode between the primary gate electrodes, the primary gate electrodes may be arranged in high density. If first trench gate electrodes are applied, the density can even be higher than for first planar gate electrodes, so that such devices can be constructed even more compact than devices having first planar gate electrodes and thus, device performance is better. Thus, having omitted p-doped zones in the n-emitter layer (common feature of the MCT), trench patterns with small dimensions, e.g. mesa widths in the 1 µm range or even below can be realized thus providing very high turn-off capability not achievable by MOS controlled thyristors.

Regarding the depth of the first trench gate electrodes in the p-base layer, on-state and static blocking performance increase with increasing trench depth as shown in the table below. The inventive devices having a trench depth up to 1.5 µm have a separate turn-on channel, i.e. a separate secondary (e.g. trench) gate electrode. The ultimate minimum on-state voltage drops are obtained, however, for first trenches that penetrate the p-base layer and end within the (n-) drift layer, thus beyond the PN-junction. For those inventive geometries, no separate turn-on channel is needed (i.e. the first trench gate electrode acts already as secondary gate electrode). The turn-off capability of devices with shallow first trench gate electrodes and deep first trench gate electrodes, penetrating into the drift layer is comparable (> 2000 A/cm² vs 1800 V at 400 K).

| trench depth | 0.5 µm (T1) | 1.0 µm | 1.5 µm (T3) | 2.5 µm | 7 µm (T2) |
|---|---|---|---|---|---|
| breakdown voltage V_{ge} = -15V | 1061.2 V | 3834.2 V | 3977.1 V | 4080.6 V | 4601.1 V |
| on-state voltage drop at 60 A/cm² | 1.549 V | 1.491 V | 1.450 V | 1.420 V | 1.345 V |
| turn-off loss E_{off} at 60A/cm², 1800 V and 400 K | 338.6 mJ | 211.4 mJ | 209.3 mJ | 205.8 mJ | 207.2 mJ |

The safe operating area (SOA) is very high due to the inherent weakness of the n-emitter and its high degree of shorting. The high density transparent n-emitter concept can be used to realize emitter clusters with a turn-on periphery by having a secondary gate electrode, which extends to the drift layer. Such a device offers short circuit capability.

The inventive semiconductor device, thus, provides a better trade-off curve (E_{off} versus V_{ce,on}) than obtainable with prior art devices. In the present invention, this is achieved by sacrificing the collector current saturation in IGBTs enabling their short circuit capability while maintaining high SOA (turn-off capability of several K A/_{cm2).}

For an inventive device having first trench gate electrodes as primary gate electrodes, a high positive gate voltage (e.g. + 15 V) may be applied in on-state condition, which creates a strong electric field from the trench gate electrode. This field attracts electrons even when they are still in the n doped emitter layer. The electron current flow is mainly in a direction parallel to the emitter side towards the n-channel (which is an accumulation layer generated in the emitter layers close to the surface towards the first trench gate electrodes). Vertical electron current flow (in a direction from the emitter side towards the collector side) proceeds then in an n-inversion layer from the n- emitter layers into p-base layer across the forward biased PN junction, however, the vertical electron current density is lower than for a prior art device. Concerning the corresponding hole current density in the on-state condition, holes do not flow in the n-inversion layer (in the p-base layer along the first gate electrode).

Therefore, in such an inventive device having first trench gate electrodes without a contact between the base layer and the emitter electrode at the first contact areas (i.e. between two primary gate electrodes), the injection efficiency for electrons can be kept low, while high transparency is achieved for holes reaching the n-emitter layers from the collector.

For an inventive semiconductor device having first planar gate electrodes as primary gate electrodes, again the n-emitters can be kept very small and transparent. There is no metal contact to the p-base layer at the emitter electrode of the device. A secondary gate electrode, exemplarily in form of a second planar gate electrode serves as a turn-on gate. When looking in the direction of electron current flow from emitter electrode to the collector electrode, shorting of the n-emitter layer (source region) at the MOS gate takes place behind the injection front (the NP junction boundary). Due to the penetration of the primary gate electrodes into the p-base below the n-emitter (trench variant, Fig. 4), when biased to cause turn-off, holes are attracted to the accumulation /inversion channels already at the bottom of the trenches. The regenerative hole current density hitting the n-emitter layer is thus much lower when using a trench geometry as compared to the case where a planar highly transparent n-emitter is used.

Because of this the shorting efficiency of the planar MOS gate is weaker than in the trench arrangement as shown in Fig. 3, where shorting occurs right at the NP junction or even before (when using trenches that penetrate further down into the p-base). In other words, the first trench gates have more strength in affecting the current flow through the n-emitter as compared to the first planar gates.

Planar gates may have advantages in the manufacturing process as no etching has to be performed for the creation of the first insulating layer and the electrically conductive gate layer.

A further object of the invention is to provide these features using a comparatively simple, manufacturable technology omitting for example parasitic voltage drops in EST devices (Emitter Switched Thyristor).

### Brief Description of Drawings

The subject matter of the invention will be explained in more detail in the following text with reference to the attached drawings, in which:
- FIG 1: shows a prior art IGBT having a second planar gate electrode;
- FIG 2: shows another prior art IGBT having a second trench gate electrode;
- FIG 3: shows a prior art MCT having a planar trench gate electrode;
- FIG 4: shows an inventive insulated gate semiconductor device having shallow first trench gate electrodes and a deep second trench gate electrode;
- FIG 5: show other inventive insulated gate semiconductor device having deep first trench gate electrodes and a deep second trench gate electrode;
- FIG 6: shows another inventive insulated gate semiconductor device having shallow first trench gate electrodes and a second planar gate electrode;
- FIG 7: shows another inventive insulated gate semiconductor device having first planar gate electrodes and a second trench gate electrode;
- FIG 8 and 9: show other inventive insulated gate semiconductor devices having first planar gate electrodes and a second planar gate electrode;
- FIG 10: shows conduction losses of the inventive device; and
- FIG 11: shows the turn-off capability of the inventive device; and
- FIG 12: shows electron and hole current density plots for different inventive devices and a prior art device.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

In Fig. 4 an inventive insulated gate power semiconductor device is shown in form of an insulated gate bipolar transistor 1, which comprises an emitter electrode 2 on an emitter side 22 and a collector electrode 25 on a collector side 27, which collector side 27 is arranged opposite to the emitter side 22. The emitter electrode 2 comprises a plurality of first contact areas 23 and at least one second contact area 24. At the first and second contact areas the emitter electrode 2 contacts at least one n doped layer.

An (n-) doped drift layer 5 is arranged between the emitter side 22 and the collector side 27. On the collector side 27 a p doped collector layer 6 is arranged. An n doped buffer layer 55 having higher maximum doping concentration than the drift layer 5 may be arranged between the drift layer 5 and the collector layer 6.

A p doped base layer 4 is arranged between the drift layer 5 and a plurality of emitter layers 3 on the emitter side 22. The base layer 4 has a base layer depth 42, which is the maximum extension of the base layer from the emitter side 22. That means the base layer depth 42 corresponds to the thickness of the emitter layer plus the thickness of the base layer (thickness given in a direction perpendicular to the emitter side 22). It is measured from the emitter side (such surface of the wafer, at which the emitter electrode 2 is arranged) to the deepest point of the base layer in the wafer from the emitter side and in a direction perpendicular to the emitter side. The base layer 4 has a base layer depth 42 of at minimum 1 µm and at most of 50 µm. The base layer 4 has at least one of a maximum doping concentration of at most 1 *10¹⁸ cm⁻³ and at minimum 1 *10⁶ cm⁻³.

The doping concentration of the base layer 4 and the drift layer 5 can be freely chosen due to the application needs and the rules for the doping concentrations given above. Exemplarily, the drift layer is constantly low-doped. For devices above 600 V the doping concentration of the drift layer is examplarily below 5*10¹⁴ cm⁻³ for a silicon wafer.

The semiconductor device is made on basis of a wafer (e.g. a silicon or GaN or SiC wafer), in which wafer the n and p doped layers of the first and second conductivity type are arranged. The emitter side and collector side are arranged opposite to each other. The emitter side shall be understood as such planar plane of the wafer, at which side the emitter electrode 2 is arranged, which plane is farest away from the collector side and in which a p or n doped layer is arranged.

A plurality of n doped emitter layers 3 having higher doping concentration than the drift layer 5 are arranged on the emitter side 22. Exemplarily, the doping concentration of the emitter layer 3 is also higher than of the base layer 4.

The emitter layers 3 are embedded into the base layer 4 such that the emitter layers 3 contact the emitter electrode 2 at the first contact areas 23 and the second contact area 24.

Each of the emitter layers 3 has a emitter layer depth 32 which is the maximum extension of the plurality of emitter layers 3 from the emitter side 22. The emitter layer depth 32 is at most 1 µm, in particular at most 0.5 µm, 0.2 µm or in particular at most 0.1 µm. The minimum depth is exemplarily 0.05 µm.

The emitter layers always have higher doping concentration than the drift layer 5. The emitter layers 3 exemplarily have a maximum doping concentration of at most 1*10¹⁸ cm⁻³, and at minimum 1*10⁶ cm⁻³, in particular between 4*10¹⁷ cm⁻³ to 6*10¹⁷ cm⁻³.

A plurality of primary gate electrodes comprise a first electrically conductive layer 74 and a first insulating layer 71, which surround and, thus, separates the first electrically conductive layer 74 from any n or p doped layer or region being in touch with the plurality of primary gate electrodes (i.e. any of the n emitter layers 3, p base layer 4 or drift layer 5, which are in touch to the gate electrode). The first insulating layers 71 exemplarily have a first insulating layer thickness between 20 to 200 nm. The first contact areas of the emitter electrode are arranged between at least two directly neighboured primary gate electrodes. The thickness of the first insulating layer shall be measured in a plane perpendicular to the emitter side 22 and in such a plane, in which the first electrically conductive layer 74 is arranged on top of the first insulating layer 71.

Exemplarily, the plurality of primary gate electrodes are first trench gate electrodes 7 as shown in Fig. 4 to 6. Each first trench gate electrode 7 is arranged laterally to the base layer 4, in a plane parallel to the emitter side 22, i.e. the base layer 4 and the first trench gate electrodes 7 alternate in a plane parallel to the emitter side 22 up to the first trench gate depth 76. Each first trench gate electrode 7 extends from the emitter side 22 up to a first trench gate depth 76, which is the maximum extension of each first gate electrode from the emitter side 22 in a direction perpendicular to the emitter side 22. The minimum first trench gate depth 76 may be at least 0.25 µm.

Exemplarily, two directly neighboured first trench gate electrodes 7 have a maximum distance 77 from each other in a plane parallel to the emitter side 22 of between 0.1 to 10 µm, exemplarily up to 5 µm. The plurality of first trench gate electrodes 7 may have a maximum extension 78 in a direction parallel to the emitter side 22 of 0.2 to 5 µm, exemplarily 0.5 to 5 µm.

The first trench gate depth 76 may be deeper than the emitter layer depth 32 of the directly neighboured emitter layers 3, but lower than the base layer depth 42, so that the base layer 4 separates each first trench gate electrode 7 from the drift layer 5. In this case the inventive insulated gate semiconductor device is switched on at the second contact areas 24 neighboured to the secondary gate electrodes as explained below (Fig. 4).

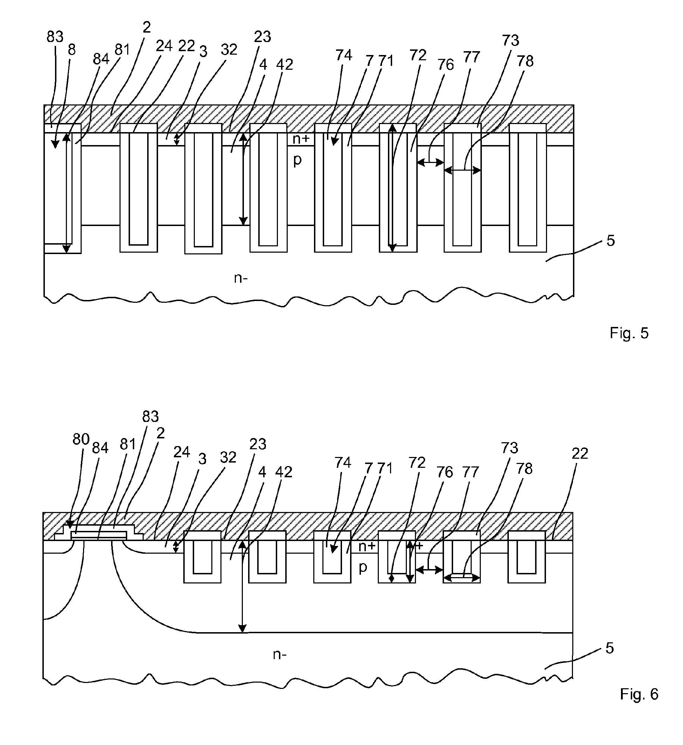

Alternatively, in case of the plurality of primary gate electrodes being first trench gate electrodes 7, the first trench gate electrodes 7 may extend from the emitter side 22 into direction of the collector side 27 up to a first trench gate depth 76, which is deeper than the base layer depth 42 (and also of course deeper than the emitter layer depth 32 of the directly neighboured emitter layers), i.e. the plurality of first trench gate electrode 7 extends to the drift layer 5 (Fig. 5). A turn-on channel is induced from the first contact areas 23 of the emitter electrode, through the emitter layers 3, base layer 4 to the drift layer 5.

The inventive insulated gate semiconductor device further comprises at least one secondary gate electrode. Each secondary gate electrode comprises a second electrically conductive layer 84 and a second insulating layer 81, which surrounds and, thus, separates the second electrically conductive layer 84 from any n or p doped layer or region being in touch with the at least one secondary gate electrode (i.e. any of the n emitter layers 3, p base layer 4, drift layer 5). The at least one second contact area 24 is arranged directly adjacent to the at least one secondary gate electrode and the at least one secondary gate electrode extends to the drift layer 5. The secondary gate electrode, therefore, differs from the primary gate electrode in that the secondary gate electrode must extend to the drift layer 5, whereas the primary gate electrodes may or may not extend to the drift layer 5. At least one such channel extending from the emitter electrode 2 to the drift layer 5 at the second contact 24 area is necessary to switch on the device.

The base layer 4 is completely separated from the plurality of first contact areas 23 by the plurality of emitter layers 3. That means that the emitter electrode does not contact the base layer 4 at the first contact areas 23. At these areas the emitter electrode 2 is only electrically connected to the n emitter layers 3. At the second contact areas 24, the emitter electrode 2 may also be solely electrically connected to the n emitter layers 3 like the contact at the first contact areas 23 (Fig. 4, 5, 6 to 9). Alternatively, the emitter electrode 2 may also be connected to the p base layer 4 at the second contact area 24.

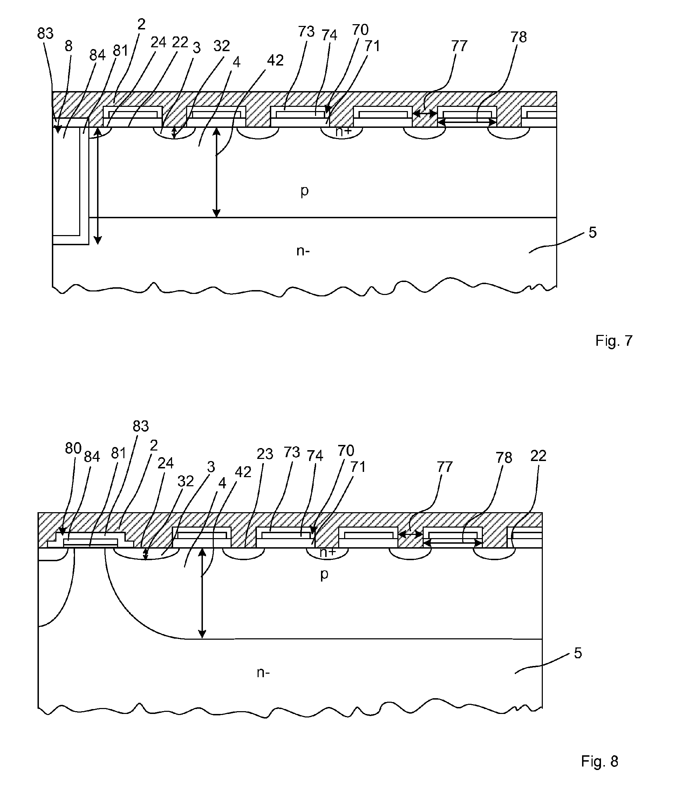

Alternatively to the primary gate electrodes being first trench gate electrodes 7, they may also be first planar gate electrodes 70 (Fig. 7 to 9). For such first planar gate electrodes 70, the first electrically conductive layer 74 is arranged on top of the emitter side 22 (i.e. on top of any emitter sided n or p doped layer) and separated from any p or n doped layer or region (emitter layers 3, base layer 4 or drift layer 5) being in touch with the plurality of first planar gate electrodes 70 by the first insulating layer 71.

In another exemplary embodiment, the at least one secondary gate electrode is at least one second trench gate electrode 8 (Fig. 4, 5 and 7), each of which comprises the second electrically conductive layer 84 and the second insulating layer 82, which surrounds and thus separates the second electrically conductive layer 84 from any layer or region of the first and second conductivity type being in touch with the at least one secondary gate electrode. The at least one second trench gate electrode 8 is arranged laterally to the base layer 4 in a plane parallel to the emitter side 22, i.e. the base layer 4 and the second trench gate electrode 8 alternate in a plane parallel to the emitter side 22 up to the base layer depth. Each of the second trench gate electrodes 8 extends from the emitter side 22 up to a second gate depth 81, which is larger than the base layer depth 42, i.e. the second trench gate electrode 8 extends to the drift layer 5.

Alternatively, the at least one secondary gate electrode is at least one second planar gate electrode 80 (Fig. 8 and 9), each of which comprises the second electrically conductive layer 84 and the second electrically insulating layer 82, wherein the second electrically insulating layer 82 is arranged on top of the emitter side 22 and separates the second electrically conductive layer 84 from any layer or region of the first and second conductivity type being in touch with the at least one secondary gate electrode.

As shown in Fig. 8, in the case of first planar gate electrodes 70, the emitter layers may be formed as separate layers, each extending from one first planar gate electrode 70 to another first planar gate electrode 70, but having the base layer 4 extending to the first planar gate electrodes 70, i.e. the emitter layers are no continuous layers, but single ones. In Fig. 9, the emitter layers are formed as one continuous layer between and below the first planar gate electrodes 70, which layer completely separates the base layer 4 from the first planar gate electrodes 70. Only the emitter layer at the second planar gate electrode 80 is separated in this case from the other emitter layer, thus enabling the p base layer 4 to extend to the second planar gate electrode 80.

The inventive insulated gate semiconductor device may be in another exemplary embodiment a reverse conducting semiconductor device. Such a device comprises an n doped further layer, which is arranged parallel to the collector side and lateral to the collector layer 6. The further n doped layer alternates with the collector layer 6. Both n doped further layer and the collector layer contact the collector electrode. The maximum doping concentration of the further layer is higher than that of the drift layer 5.

These examples shall not limit the scope of the invention. The above mentioned designs and arrangements are just examples for any kinds of possible designs and arrangements for the enhancement layer(s).

In another embodiment, the conductivity types are switched, i.e. all layers of the first conductivity type are p type (e.g. the drift layer 5, the emitter layer 3) and all layers of the second conductivity type are n type (e.g. base layer 4, the collector layer 6).

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

### Reference List

- 1: Inventive insulated gate semiconductor device
- 100: prior art IGBT with planar gate
- 120: prior art IGBT with trench gate
- 2: emitter electrode
- 22: emitter side
- 23: first contact area
- 24: second contact area
- 25: collector electrode
- 27: collector side
- 3: emitter layer
- 32: emitter layer depth
- 35: channel region
- 4: base layer
- 42: base layer depth
- 45: p source region
- 5: drift layer
- 55: buffer layer
- 6: collector layer
- 7: first trench gate electrode
- 71: first insulating layer
- 72: first insulation layer thickness
- 73: third insulating layer
- 74: first electrically conductive layer
- 76: first trench gate depth
- 77: distance between first gate electrodes
- 78: maximum extension of first gate electrodes
- 70: first planar gate electrode
- 8: second trench gate electrode
- 81: second insulating layer
- 83: fourth insulating layer
- 84: second electrically conductive layer
- 86: second trench gate depth
- 80: second planar gate electrode

## Claims

1. An insulated gate power semiconductor device (1) having
- an emitter electrode (2) on an emitter side (22) and a collector electrode (25) on a collector side (27), which collector side (27) is arranged opposite to the emitter side (22), wherein the emitter electrode (2) comprises a plurality of first contact areas (23) and at least one second contact area (24),
- a drift layer (5) of a first conductivity type, which is arranged between the emitter side (22) and the collector side (27),
- a collector layer (6) of a second conductivity type, which is different from the first conductivity type and which is arranged between the drift layer (5) and the collector electrode (25),
- a plurality of emitter layers (3) of the first conductivity type, each of which has a higher doping concentration than the drift layer (5), each of which is arranged at the emitter side (22), each of which contacts the emitter electrode (2) at one of the plurality of first contact areas (23) or the at least one second contact area (24) and each of which has an emitter layer depth (32) which is the maximum extension of the plurality of emitter layers (3) from the emitter side (22),
- a base layer (4) of the second conductivity type, which is arranged between the drift layer (5) and the plurality of emitter layers (3), wherein the base layer (4) has a base layer depth (42), which is the maximum extension of the base layer from the emitter side (22),
- a plurality of primary gate electrodes, each of which comprises a first electrically conductive layer (74) and a first insulating layer (71), which separates the first electrically conductive layer (74) from any layer or region of the first and second conductivity type being in touch with the plurality of primary gate electrodes, wherein each first contact area (23) is arranged between at least two directly neighboured primary gate electrodes,
- at least one secondary gate electrode, each of which comprises a second electrically conductive layer (84) and a second insulating layer (81), which separates the second electrically conductive layer (84) from any layer or region of the first and second conductivity type being in touch with the at least one secondary gate electrode, wherein the at least one second contact area (24) is arranged adjacent to the at least one secondary gate electrode and wherein the at least one secondary gate electrode extends to the drift layer (5),
- **characterized in, that**
- the base layer (4) is completely separated from the plurality of first contact areas (23) by the plurality of emitter layers (3).

2. The insulated gate power semiconductor device according to claim 1, **characterized in that** the plurality of emitter layers (3) have a maximum doping concentration of at most 1 *10¹⁸ cm⁻³, and at minimum 1 *10¹⁶ cm⁻³, in particular between 4*10¹⁷ cm⁻³ to 6*10¹⁷ cm^{-3.}

3. The insulated gate power semiconductor device according to any of the claims 1 and 2, **characterized in that** the emitter layer depth (32) is at most 1 µm, in particular at most 0.5 µm, 0.2 µm or in particular at most 0.1 µm and in particular at minimum 0.05 µm.

4. The insulated gate power semiconductor device according to any of the claims 1 to 3, **characterized in that** the base layer (4) has at least one of a maximum doping concentration of at most 1 *10¹⁸ cm⁻³ and at minimum 1 *10¹⁶ cm⁻³, and a base layer depth (42) of at minimum 1 µm and at most of 50 µm.

5. The insulated gate power semiconductor device according to any of the claims 1 to 4, **characterized in that** the plurality of primary gate electrodes are first trench gate electrodes (7), wherein each first trench gate electrode (7) is arranged laterally to the base layer (4) in a plane parallel to the emitter side (22), and wherein each first trench gate electrode (7) extends from the emitter side (22) up to a first trench gate depth (76), which is the maximum extension of each first gate electrode from the emitter side (22), which is deeper than the emitter layer depth (32) of the directly neighboured emitter layers and lower than the base layer depth (42), so that the base layer (4) separates each first trench gate electrode (7) from the drift layer (5).

6. The insulated gate power semiconductor device according to any of the claims 1 to 4, **characterized in that** the plurality of primary gate electrodes are first trench gate electrodes (7), wherein each first trench gate electrode (7) is arranged laterally to the base layer (4) in a plane parallel to the emitter side (22), and wherein each first trench gate electrode (7) extends from the emitter side (22) up to a first trench gate depth (76), which is deeper than the base layer depth (42), so that the plurality of first trench gate electrodes (7) extends to the drift layer (5).

7. The insulated gate power semiconductor device according to any of the claims 5 and 6, **characterized in that** each first trench gate electrode (7) has a first trench gate depth (76) of at minimum 0.25 µm.

8. The insulated gate power semiconductor device according to any of the claims 5 and 6, **characterized in that** two directly neighboured first trench gate electrodes (7) have a maximum distance (77) from each other in a plane parallel to the emitter side (22) of between 0.1 to 10 µm.

9. The insulated gate power semiconductor device according to any of the claims 5 to 8, **characterized in that** the plurality of first trench gate electrodes (7) have a maximum extension (78) in a direction parallel to the emitter side (22) of 0.2 to 5 µm.

10. The insulated gate power semiconductor device according to any of the claims 1 to 4, **characterized in that** the plurality of primary gate electrodes are first planar gate electrodes (70), wherein the first electrically conductive layer (74) is arranged on top of the emitter side (22) and separated from any layer or region of the first and second conductivity type being in touch with the plurality of first planar gate electrodes (70).

11. The insulated gate power semiconductor device according to any of the claims 1 to 10, **characterized in that** the plurality of first insulating layers (71) have a first insulating layer thickness (72) between 20 to 200 nm.

12. The insulated gate power semiconductor device according to any of the claims 1 to 11, **characterized in that** the at least one secondary gate electrode is at least one second trench gate electrode (8), each of which comprises the second electrically conductive layer (84) and the second insulating layer (82), which surrounds and thus separates the second electrically conductive layer (84) from any layer or region of the first and second conductivity type being in touch with the at least one secondary gate electrode, wherein the at least one second trench gate electrode (8) is arranged laterally to the base layer (4) in a plane parallel to the emitter side (22), and each of which second trench gate electrode (8) extends from the emitter side (22) up to a second trench gate depth (86), which is larger than the base layer depth (42).

13. The insulated gate power semiconductor device according to any of the claims 1 to 11, **characterized in that** the at least one secondary gate electrode is at least one second planar gate electrode (80), each of which comprises the second electrically conductive layer (84) and the second electrically insulating layer (81), wherein the second electrically insulating layer (81) is arranged on top of the emitter side (22) and separates the second electrically conductive layer (84) from any layer or region of the first and second conductivity type being in touch with the at least one secondary gate electrode.

14. The insulated gate power semiconductor device according to any of the claims 1 to 13, **characterized in that** the device is a reverse conducting semiconductor device

15. The insulated gate power semiconductor device according to any of the claims 1 to 14, **characterized in that** the semiconductor device comprises one of a silicon or GaN or SiC wafer, in which wafer the layers of the first and second conductivity type are arranged.
